**Europäisches Patentamt**

**European Patent Office**

**Office européen des brevets**

(11) Veröffentlichungsnummer: **0 033 472**

**A2**

# (12) EUROPÄISCHE PATENTANMELDUNG

(21) Anmeldenummer: **81100396.1**

(22) Anmeldetag: **20.01.81**

(51) Int. Cl.³: **H 05 K 7/12**
**H 05 K 7/10**

(30) Priorität: **01.02.80 DE 3003726**

(43) Veröffentlichungstag der Anmeldung:
**12.08.81 Patentblatt 81/32**

(84) Benannte Vertragsstaaten:
**CH FR GB IT LI NL SE**

(71) Anmelder: **SIEMENS AKTIENGESELLSCHAFT Berlin**
**und München**
**Postfach 22 02 61**
**D-8000 München 22(DE)**

(72) Erfinder: **Kuballa, Siegfried, Ing. (grad.)**
**Ertlstrasse 30**
**D-8031 Puchheim(DE)**

(72) Erfinder: **Wechsler, Klaus, Ing. (grad.)**
**Klenzestrasse 21**
**D-8000 München 5(DE)**

(54) **Halterung für elektrische Bauteile.**

(57) Die Erfindung bezieht sich auf eine Halterung für elektrische Bauteile (1), die auf einer Baugruppe (5) steckbar angeordnet sind.

Das Bauteil (1) wird von einem Rahmen (6) aufgenommen, der mittels Rasthaken (12) in der Baugruppe (5) verrastbar ist. Das Bauteil (1) wird mittels einer Abdeckung (8) im Rahmen (6) festgeklemmt. Die Abdeckung (8) weist eine als Verzahnung (9) ausgebildete, formschlüssige Verbindung mit dem Rahmen (6) auf. Zum Herausziehen des Bauteils (1) aus Sockelkontakten (4) ist um das Bauteil (1) und die Abdeckung (8) eine Schlaufe (15) gelegt.

FIG 1

SIEMENS AKTIENGESELLSCHAFT
Berlin und München

Unser Zeichen
VPA 80 P 2308 E

## Halterung für elektrische Bauteile.

Die Erfindung bezieht sich auf eine Halterung für elektrische Bauteile, die auf einer Baugruppe steckbar angeordnet sind.

Es ist bereits allgemein bekannt, auswechselbare, elektrische Bauteile in Stecksockeln oder einzelnen Sockelkontakten anzuordnen. Die Bauteile werden in diesem Fall nur über die Kontaktkräfte zwischen den Kontaktstiften des Bauteils und den Sockelkontakten gehalten. Nach einem mehrmaligen Stecken eines Bauteils kann die Kontaktkraft abnehmen, so daß eine sichere Halterung der Bauteile nicht immer gewährleistet ist.

Der Erfindung liegt daher die Aufgabe zugrunde, eine Halterung für elektrische Bauteile anzugeben, die ein Lockern oder ein Herausfallen der Bauteile aus den Sockelkontakten verhindert.

Erfindungsgemäß wird die Aufgabe bei der Halterung der eingangs genannten Art gelöst durch einen das Bauteil aufnehmenden Rahmen, der mittels Rasthaken in der Baugruppe verrastbar ist und durch eine das Bauteil mittels einer formschlüssigen Verbindung im Rahmen festklemmenden Abdeckung.

Die Anordnung gemäß der Erfindung hat den Vorteil, daß eine gute elektrische Verbindung zwischen den Kontaktstiften des Bauteils und den Sockelkontakten auch bei Erschütterungen sichergestellt ist. Die gute elektrische Verbindung wird auch bei häufigem Stecken eines Bauteils gewährleistet.

Ret 1 Ram /31.1.1980

0033472

Bei Verwendung der Halterung werden auf einfache Weise unterschiedliche Höhen der Bauteile in vorteilhafter Weise ausgeglichen, wenn die formschlüssige Verbindung zwischen der Abdeckung und dem Rahmen durch eine Verzahnung erfolgt.

Um zu verhindern, daß das im Rahmen enthaltene Bauteil um 180° verdreht in die Sockelkontakte gesteckt wird, ist es vorteilhaft, wenn die Rasthaken außermittig angeordnet sind.

Zum Lösen des Rahmens aus der Baugruppe ist es günstig, wenn die Rasthaken an Führungsstegen angeordnet sind, die rückwärtig verlängert sind und über den Rahmen hinausragen. In diesem Fall kann durch Zusammendrücken der rückwärtigen Verlängerungen, ähnlich wie bei einer Klammer, die Verrastung des Rahmens in der Baugruppe gelöst werden.

Zur Führung des Bauteils in Längsrichtung ist es von Vorteil, wenn der Rahmen Rippen aufweist, die zwischen die Kontaktstifte des Bauteils hindurchragen.

Eine seitliche Führung des Bauteils wird auf einfache Weise dadurch erreicht, daß die Abdeckung das Bauteil teilweise umfaßt und daß die Kontaktstifte an der Innenseite der Abdeckung anliegen.

Falls die Oberseite der Bauteile zugänglich sein muß, ist es zweckmäßig, wenn die Abdeckung rahmenförmig ausgebildet ist und durch Stege das Bauteil nur teilweise abdeckt. Falls beispielsweise das Bauteil ein integrierter Schaltkreis ist, der einen durch UV-Licht löschbaren Speicher enthält, ist es zweckmäßig, wenn die Abdeckung so ausgebildet ist, daß ein auf der Oberseite des des Bauteils angeordnetes Fenster freigelassen wird.

Falls das Bauteil in einen handelsüblichen Stecksockel eingesteckt wird, der auf der Baugruppe befestigt ist, ist es von Vorteil, wenn Führungsrippen an der Innenseite des Rahmens vorgesehen sind, die diesen im Stecksockel zentrieren.

Um das Bauteil auf einfache Weise aus den Sockelkontakten herausziehen zu können, ist es vorteilhaft, wenn zwischen dem Bauteil und dem Stecksockel eine Schlaufe festgeklemmt ist, die das Bauteil und die Abdeckung umfaßt. Mit Hilfe dieser Schlaufe kann nach dem Lösen der Verrastung des Rahmens in der Baugruppe das Bauteil auf einfache Weise entfernt werden. Falls für die Baugruppe nur eine geringe Einbauhöhe zur Verfügung steht, kann der überstehende Teil der Schlaufe an die Abdeckung angedrückt werden. In diesem Fall ist es auch zweckmäßig, auf die rückwärtige Verlängerung der mit den Rasthaken versehenen Führungsstege zu verzichten.

Im folgenden wird ein Ausführungsbeispiel der Halterung anhand von Zeichnungen näher erläutert.
Es zeigen:
Fig. 1 einen Längsschnitt durch die Halterung,
Fig. 2 einen Querschnitt durch die Halterung.

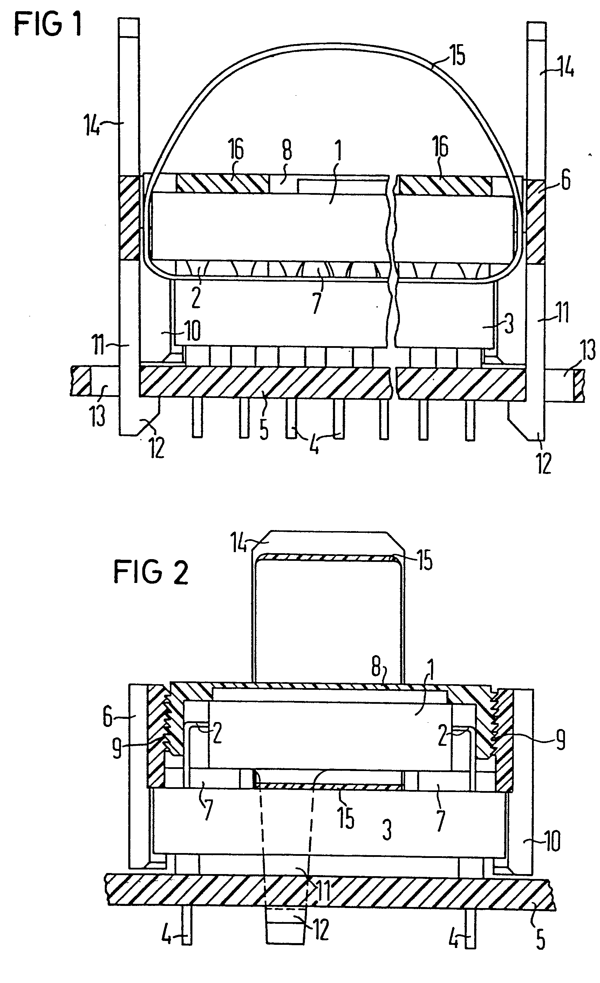

Bei den Darstellungen in Fig. 1 und Fig. 2 ist ein Bauteil 1 mit seinen Kontaktstiften 2 in einen Stecksockel 3 eingesteckt. Der Stecksockel 3 weist Sockelkontakte 4 auf, die in einer Baugruppe 5 befestigt, beispielsweise verlötet sind. Das Bauteil 1 ist beispielsweise ein integrierter Schaltkreis, der in einem bekannten Gehäuse, das als Dual-in-line Gehäuse bezeichnet wird, untergebracht ist. Das Bauteil 1 wird von einem Rahmen 6 umgeben, der als Kunststoffteil ausgebildet ist. Der Rahmen 6 weist Rippen 7 auf, die zwischen die Kontaktstifte 2 des Bauteils 1 hindurchragen und das Bauteil 1 in Längsrichtung zentrieren.
In den Rahmen 6 ist eine Abdeckung 8 eingedrückt, die unter Verwendung einer formschlüssigen Verbindung das Bauteil 1 in vertikaler Richtung festklemmt. Die formschlüssige Verbindung ist vorzugsweise als Verzahnung 9 ausgebildet. Mit Hilfe dieser Verzahnung 9 werden auf einfache Weise Toleranzen in der Höhe des Bauteiles 1 ausgeglichen. Die Abdeckung 8 umfaßt das Bauteil 1 in der Weise, daß die Kontaktstifte 2 an seiner Innenseite anliegen und das Bauteil damit seitlich geführt wird, so daß auch Toleranzen in den Abmessungen der Kontaktstifte 2 ausgeglichen werden.

Das Bauteil 1 wird vor dem Einstecken in den Stecksockel 3 in den Rahmen 6 gelegt und durch die Abdeckung 8 im Rahmen festgeklemmt. Anschließend wird es in den Stecksockel 3 eingedrückt. Der Rahmen 6 kann Führungsrippen 10 enthalten, die ihn beim Einstecken des Bauteils 1 in den Stecksockel 3 zentrieren.

Der Rahmen 6 weist Führungsrippen 11 auf, die beim Einstecken des Bauteils 1 in den Stecksockel 3 durch die Baugruppe 5 hindurchragen. Die Enden dieser Führungsrippen sind mit Rastnasen 12 versehen, mit denen der Rahmen 6 in der Baugruppe 5 verrastet wird. Die Baugruppe 5 enthält zu diesem Zweck entsprechende Ausnehmungen 13. Die mit den Rastnasen 12 versehenen Führungsrippen 11 sind vorzugsweise außermittig angeordnet, um ein um $180^{o}$ verdrehtes Stecken des Bauteils 1 zu verhindern.

Falls genügend Einbauhöhe für die Bauteile zur Verfügung steht, sind die Führungsrippen 11 rückwärtig so weit verlängert, daß sie über den Rahmen 6 hinausragen und Ansätze 14 bilden. Mit Hilfe dieser Ansätze kann die Verrastung auf einfache Weise durch Zusammendrücken, entsprechend einer Klammer, gelöst werden. Falls die Einbauhöhe nicht zur Verfügung steht, kann auf die rückwärtigen Verlängerungen verzichtet werden. In diesem Fall müssen die Rastnasen 12 in bekannter Weise manuell oder mittels eines entsprechenden Werkzeugs auseinandergedrückt werden.

Zum einfachen Herausziehen des Bauteils 1 aus dem Stecksockel 3 ist eine Schlaufe 15 vorgesehen, die zwischen dem Bauteil 1 und dem Stecksockel 3 eingeklemmt ist und das Bauteil 1 und die Abdeckung 8 umfaßt.

Falls das Bauteil 1 von oben teilweise zugänglich sein soll oder falls die Oberseite nicht eben ist, kann die Abdeckung 8 rahmenförmig ausgebildet sein. In diesem Fall wird das Bauteil 1 durch Stege 16 der Abdeckung 8 gehalten.

Die aus dem Rahmen 6 und der Abdeckung 8 gebildete Halterung eignet sich insbesondere dann, wenn die Bauteile 1 durch Wartungspersonal oder durch einen Kunden selbst in einem Gerät ausgetauscht werden sollen. Das Bauteil 1 wird in diesem Fall bereits in der Fertigung lagerichtig in den Rahmen 6 eingesetzt und durch die Abdeckung 8 festgeklemmt. Am Gerät wird dann das Bauteil 1 gemeinsam mit seiner Halterung eingesteckt oder ausgewechselt. Ein Auswechseln eines Bauteils 1 beim Kunden in der Halterung ist nicht vorgesehen, um eine Zerstörung des Bauteils bei unsachgemäßer Behandlung zu verhindern.

Die Halterung kann so ausgebildet sein, daß mehrere Bauteile untergebracht werden können und damit gleichzeitig ausgetauscht werden können.

9 Patentansprüche
2 Figuren

0033472

Patentansprüche

1. Halterung für elektrische Bauteile, die auf einer Baugruppe steckbar angeordnet sind, g e k e n n z e i c h n e t durch einen das Bauteil (1) aufnehmenden Rahmen (6), der mittels Rasthaken (12) in der Baugruppe (5) verrastbar ist und durch eine das Bauteil (1) mittels einer formschlüssigen Verbindung (9) im Rahmen (6) festklemmenden Abdeckung (8).

2. Halterung nach Anspruch 1, d a d u r c h  g e k e n n z e i c h n e t, daß die formschlüssige Verbindung zwischen der Abdeckung (8) und dem Rahmen (6) durch eine Verzahnung erfolgt.

3. Halterung nach Anspruch 1 oder Anspruch 2, d a d u r c h  g e k e n n z e i c h n e t, daß die Rasthaken (12) außermittig angeordnet sind.

4. Halterung nach einem der Ansprüche 1 bis 3, d a d u r c h  g e k e n n z e i c h n e t, daß die Rasthaken (12) an Führungsstegen (11) angeordnet sind, die rückwärtig verlängert sind und über den Rahmen (6) hinausragen.

5. Halterung nach einem der Ansprüche 1 bis 4, d a d u r c h  g e k e n n z e i c h n e t, daß der Rahmen (6) Rippen (7) aufweist, die zwischen die Kontaktstifte (2) des Bauteils (1) hindurchragen.

6. Halterung nach einem der Ansprüche 1 bis 5, d a d u r c h  g e k e n n z e i c h n e t, daß die Abdeckung (8) das Bauteil (1) teilweise umfaßt und daß die Kontaktstifte (2) an der Innenseite der Abdeckung (8) anliegen.

7. Halterung nach einem der Ansprüche 1 bis 6, d a d u r c h  g e k e n n z e i c h n e t, daß die Abdeckung

(8) rahmenförmig ausgebildet ist und durch Stege (16) das Bauteil (1) nur teilweise abdeckt.

8. Halterung nach einem der Ansprüche 1 bis 7, d a - durch gekennzeichnet, daß Führungsrippen (10) an der Innenseite des Rahmens (6) vorgesehen sind, die diesen in einem Stecksockel (3) zentrieren.

9. Halterung nach einem der Ansprüche 1 bis 8, d a - durch gekennzeichnet, daß zwischen dem Bauteil (1) und dem Stecksockel (3) eine Schlaufe (15) festgeklemmt ist, die das Bauteil (1) und die Abdeckung (8) umfaßt.

FIG 1

FIG 2